# EUROPEAN PATENT APPLICATION

(11) **EP 4 529 019 A1**
(43) Date of publication of application: **26.03.2025**
(21) Application number: 23807360.5
(22) Date of filing: 18.04.2023
(51) Int. Cl.: H03F 1/02, H03F 3/24

(54) **TRACKER CIRCUIT AND VOLTAGE SUPPLYING METHOD**

(30) Priority: 18.05.2022 US 202263343195 P
(71) Applicant: Murata Manufacturing Co., Ltd., Nagaokakyo-shi, Kyoto 617-8555 (JP)
(72) Inventor: HOVERSTEN, John, Cambridge, Massachusetts 02142 (US); PERREAULT, David, Cambridge, Massachusetts 02142 (US); TKACHENKO, Yevgeniy, Cambridge, Massachusetts 02142 (US); KOGURE, Takeshi, Nagaokakyo-shi, Kyoto 617-8555 (JP); MATSUI, Toshiki, Nagaokakyo-shi, Kyoto 617-8555 (JP); FUKUDA, Yuuki, Nagaokakyo-shi, Kyoto 617-8555 (JP)
(74) Representative: Stöckeler, Ferdinand
(86) International application number: PCT/JP2023/015457
(87) International publication number: WO 2023/223747

(57) **Abstract**

A tracker circuit (1) includes a pre-regulator circuit (10) configured to convert an input voltage into a regulated voltage using a power inductor (L71), a switched-capacitor circuit (20) configured to generate a plurality of discrete voltages, based on the regulated voltage, and a power modulation circuit (30) configured to select at least one voltage from the plurality of discrete voltages and output the at least one voltage to an output terminal (141), the pre-regulator circuit (10) is configured to output the input voltage or the regulated voltage to an output terminal (142) via a bypass path (BP1) configured to bypass the switched-capacitor circuit (20) and the power modulation circuit (30), and the bypass path (BP1) is configured to connect, to the output terminal (142), a path (P1) between the power inductor (L71) and the switched-capacitor circuit (20).

## Description

### Technical Field

The present invention relates to tracker circuits and a voltage supply method.

### Background Art

In recent years, power-added efficiency (PAE) has been improved through the application of an envelope tracking (ET) mode to power amplifier (PA) circuits. Patent Document 1 discloses technology related to a digital ET mode, in which multiple discrete voltages are supplied.

### Citation List

### Patent Document

Patent Document 1: U.S. Patent No. 9,755,672

### Summary of Invention

### Technical Problem

However, with the existing technology described above, power supply voltage may be degraded in a constant voltage mode, in which a constant voltage is supplied to power amplifiers.

The present invention thus provides tracker circuits and a voltage supply method that can suppress power supply voltage degradation.

### Solution to Problem

A tracker circuit according to an aspect of the present invention includes a pre-regulator circuit configured to convert an input voltage into a regulated voltage using a power inductor, a switched-capacitor circuit configured to generate a plurality of discrete voltages, based on the regulated voltage, and a power modulation circuit (supply modulator) configured to select at least one voltage from the plurality of discrete voltages and output the at least one voltage to a first output terminal, the pre-regulator circuit is configured to output the input voltage or the regulated voltage to a second output terminal via a first bypass path configured to bypass the switched-capacitor circuit and the power modulation circuit, and the first bypass path is configured to connect, to the second output terminal, a path between the power inductor and the switched-capacitor circuit.

A tracker circuit according to an aspect of the present invention includes a pre-regulator circuit, a switched-capacitor circuit connected to the pre-regulator circuit, a power modulation circuit connected to the switched-capacitor circuit, an input terminal, a first output terminal, and a second output terminal. The switched-capacitor circuit includes a first capacitor having a first electrode and a second electrode, a second capacitor having a third electrode and a fourth electrode, a first switch, a second switch, a third switch, a fourth switch, a fifth switch, a sixth switch, a seventh switch, and an eighth switch. One end of the first switch and one end of the third switch are connected to the first electrode. One end of the second switch and one end of the fourth switch are connected to the second electrode. One end of the fifth switch and one end of the seventh switch are connected to the third electrode. One end of the sixth switch and one end of the eighth switch are connected to the fourth electrode. Another end of the first switch, another end of the second switch, another end of the fifth switch, and another end of the sixth switch are connected to each other. Another end of the third switch is connected to another end of the seventh switch. Another end of the fourth switch is connected to another end of the eighth switch. The power modulation circuit includes a ninth switch connected between the first output terminal and the other ends of the first, second, fifth, and sixth switches, and a tenth switch connected between the first output terminal and the other ends of the third and seventh switches. The pre-regulator circuit includes an eleventh switch connected between the input terminal and one end of a power inductor, and a twelfth switch connected between the one end of the power inductor and ground. Another end of the power inductor is connected to the other ends of the first, second, fifth, and sixth switches. The other end of the power inductor is connected to the second output terminal with a first bypass path, which is configured to bypass the switched-capacitor circuit and the power modulation circuit, interposed therebetween.

A voltage supply method according to an aspect of the present invention includes converting an input voltage into a regulated voltage using a power inductor, generating a plurality of discrete voltages, based on the regulated voltage, selecting at least one voltage from the plurality of discrete voltages and supplying the at least one voltage to a first amplifier, based on an envelope signal of a radio frequency signal, and skipping generation of the plurality of discrete voltages and selection of the at least one voltage, and supplying the input voltage or the regulated voltage to a second amplifier.

### Advantageous Effects of Invention

According to a tracker circuit, for example, according to an aspect of the present invention, power supply voltage degradation can be suppressed.

### Brief Description of Drawings

[Fig. 1A] Fig. 1A is a graph illustrating an example of power supply voltage transition in an average power tracking (APT) mode.
[Fig. 1B] Fig. 1B is a graph illustrating an example of power supply voltage transition in an analog envelope tracking (A-ET) mode.
[Fig. 1C] Fig. 1C is a graph illustrating an example of power supply voltage transition in a digital envelope tracking (D-ET) mode.
[Fig. 2] Fig. 2 is a circuit configuration diagram of a communication device according to an embodiment.
[Fig. 3] Fig. 3 is a circuit configuration diagram of a pre-regulator circuit, a switched-capacitor circuit, a power modulation circuit, and a filter circuit according to the embodiment.
[Fig. 4] Fig. 4 is a circuit configuration diagram of a digital control circuit according to the embodiment.
[Fig. 5] Fig. 5 is a flowchart illustrating a voltage supply method performed by a tracker circuit according to the embodiment.
[Fig. 6] Fig. 6 is a plan view of a tracker module according to the embodiment.
[Fig. 7] Fig. 7 is a plan view of the tracker module according to the embodiment.
[Fig. 8] Fig. 8 is a cross-sectional view of the tracker module according to the embodiment.
[Fig. 9] Fig. 9 is a circuit configuration diagram of a communication device according to another embodiment. Description of Embodiments

In the following, embodiments of the present invention will be described in detail using the drawings. Note that all of the embodiments described below are intended to represent generic or specific examples. The numerical values, shapes, materials, constituent elements, and arrangement and connection forms of the constituent elements illustrated in the following embodiments are examples and are not intended to limit the present invention.

Each drawing is a schematic diagram with emphasis, omissions, or proportions adjusted as appropriate to illustrate the present invention. The drawings are not always exact depictions and may differ from actual shapes, positional relationships, and proportions. In each diagram, the same symbols are assigned to substantially identical configurations, and redundant descriptions may be omitted or simplified.

In each of the following drawings, the x-axis and y-axis are axes that are orthogonal to each other in a plane parallel to the main surface of a module laminate. Specifically, in a case where a module laminate has a rectangular shape in plan view, the x-axis is parallel to a first side of the module laminate, and the y-axis is parallel to a second side of the module laminate orthogonal to the first side. The z-axis is the axis perpendicular to the main surface of the module laminate. The positive direction of the z-axis indicates the upward direction, and the negative direction of the z-axis indicates the downward direction.

Regarding circuit configurations in the present invention, "connected" includes not only direct connections formed by connection terminals, wiring conductors, or both, but also electrical connections formed via other circuit elements. "Connected between A and B" means that a connection is established between A and B, linking both, and also that a connection is made in series with a path between A and B. The "path between A and B" refers to a path formed by conductors that electrically connect A to B.

In the component arrangement of the present invention, "a component is arranged in or on a laminate" includes a component being arranged on the main surface of the laminate and a component being arranged within the laminate. "A component is arranged on the main surface of a laminate" includes, in addition to a component being arranged in contact with the main surface of the laminate, a component being arranged above the main surface without being in contact with the main surface (for example, a component is stacked on top of another component arranged in contact with the main surface). Moreover, "a component is arranged on the main surface of a laminate" may include a component being arranged in a recess formed in the main surface. "A component is arranged within a laminate" includes not only a component being encapsulated within a module laminate but also a case where the entire component is arranged between the two main surfaces of the laminate but part of the component remains uncovered, and a case where only a portion of the component is arranged within the laminate.

In the present invention, "terminal" refers to a point at which a conductor in an element terminates. Note that in a case where the impedance of the path between elements is sufficiently low, the terminal is interpreted not just as a single point but as any point on the path between the elements or as the entire path.

Terms indicating relationships between elements, such as "parallel" and "perpendicular", and terms describing the shapes of elements, such as "rectangle", as well as numerical ranges are not intended to express exact meanings only but also to include substantially equivalent ranges, such as errors of a few percent.

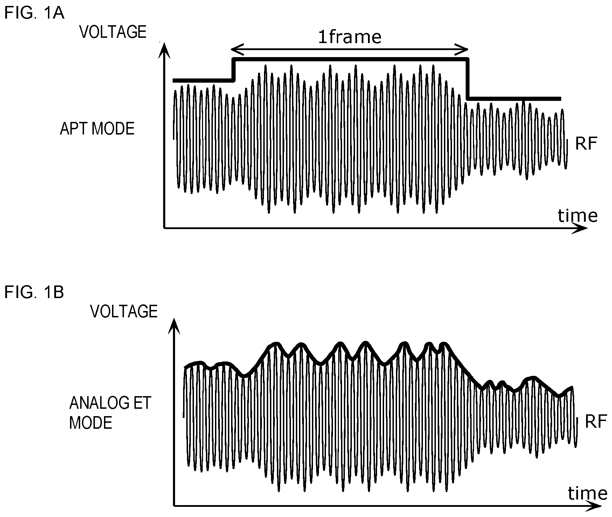

First, as a technique for highly efficient amplification of radio frequency (RF) signals, a tracking mode will be described in which a power amplifier (PA) is supplied with a power supply voltage that is dynamically regulated over time on the basis of an RF signal. The tracking mode is a mode in which the power supply voltage applied to a power amplifier circuit is dynamically regulated. There are several types of tracking modes, but in the following, an average power tracking (APT) mode and an envelope tracking (ET) mode (including an analog ET mode and a digital ET mode) will be described with reference to Figs. 1A to 1C. In Figs. 1A to 1C, the horizontal axis represents time, and the vertical axis represents voltage. The thick solid line represents power supply voltage, and the thin solid line (waveform) represents modulation signal.

Fig. 1A is a graph illustrating an example of power supply voltage transition in the APT mode. In the APT mode, the power supply voltage is varied to multiple discrete voltage levels in units of one frame on the basis of average power.

Frames refer to units that constitute an RF signal (modulation signal). For example, in the 5th Generation New Radio (5G NR) and Long Term Evolution (LTE), a frame includes 10 subframes, each subframe includes multiple slots, and each slot includes multiple symbols. The subframe length is 1 ms, and the frame length is 10 ms.

Note that the mode in which the voltage level is varied in units of one frame or larger on the basis of average power is referred to as APT mode, and the APT mode is distinguished from the mode in which the voltage level is varied in units smaller than one frame (for example, a subframe, a slot, or a symbol). For example, the mode in which the voltage level is varied in units of a symbol is referred to as symbol power tracking (SPT) mode and is distinguished from the APT mode.

Fig. 1B is a graph illustrating an example of power supply voltage transition in the analog ET mode. In the analog ET mode, the envelope of the modulation signal is tracked by continuously varying the power supply voltage on the basis of the envelope signal.

An envelope signal is a signal that indicates the envelope of a modulation signal. An envelope value is expressed, for example, as the square root of (I² + Q²). In this case, (I, Q) represents a constellation point. A constellation point is a point that represents, on a constellation diagram, a signal modulated by digital modulation. (I, Q) is determined by a baseband integrated circuit (BBIC), for example, on the basis of transmission information, for example.

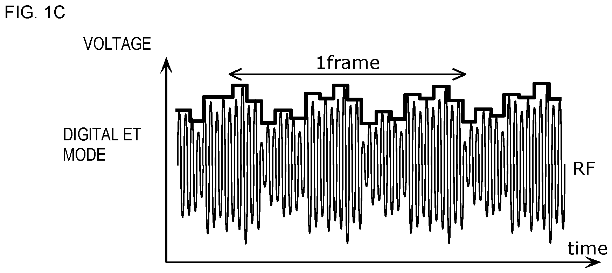

Fig. 1C is a graph illustrating an example of power supply voltage transition in the digital ET mode. In the digital ET mode, the envelope of a modulation is tracked by varying the power supply voltage to multiple discrete voltage levels within a single frame on the basis of the envelope signal.

### (Embodiments)

The following is a description of embodiments. A communication device 7 according to the present embodiment can be used to provide wireless connections. For example, the communication device 7 can be mounted in user equipment (UE) in cellular networks, such as cell phones, smartphones, tablet computers, and wearable devices. In another example, the communication device 7 can be implemented to provide wireless connections to Internet of Things (IoT) sensors and devices, medical/healthcare devices, cars, unmanned aerial vehicles (UAVs) (commonly known as drones), and automated guided vehicles (AGVs). In yet another example, the communication device 7 can be implemented to provide wireless connections at a wireless access point or a wireless hotspot.

### [1.1 Circuit Configuration of Communication Device 7]

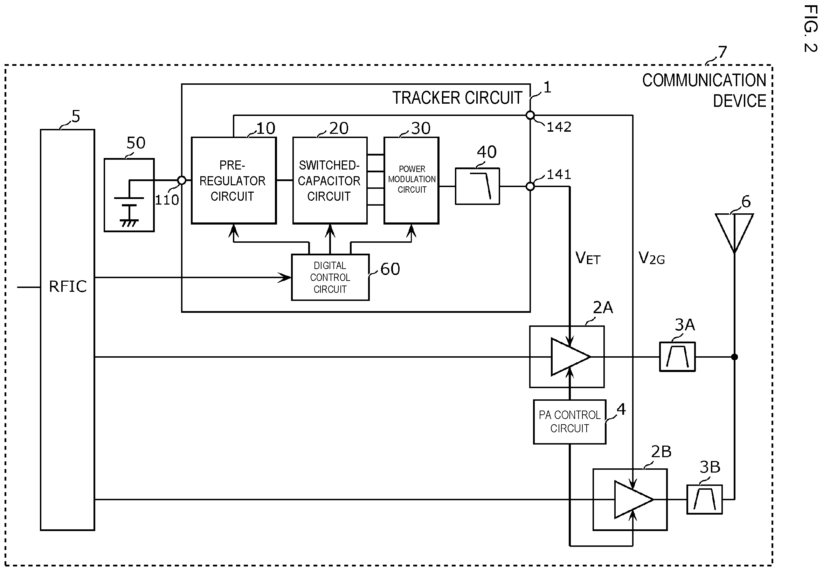

First, the circuit configuration of the communication device 7 will be described with reference to Fig. **2.** Fig. 2 is a circuit configuration diagram of the communication device 7 according to the present embodiment. As illustrated in Fig. 2, the communication device 7 according to the present embodiment includes a tracker circuit 1, power amplifiers 2A and 2B, filters 3A and 3B, a power amplifier (PA) control circuit 4, a radio frequency integrated circuit (RFIC) 5, an antenna 6, and a direct current (DC) power source 50.

The tracker circuit 1 can supply a power supply voltage V_{ET} based on the digital ET mode to the power amplifier 2A. The tracker circuit 1 can also supply a power supply voltage V_{2G} based on a constant voltage mode to the power amplifier 2B. In this case, the tracker circuit 1 can supply the power supply voltages to the power amplifiers 2A and 2B in a selective manner via output terminals 141 and 142.

Note that the tracker circuit 1 may be capable of supplying the power supply voltages to other power amplifiers as well as the power amplifiers 2A and 2B. The tracker circuit 1 may also supply power supply voltages based on other tracker modes (for example, the APT mode and the SPT mode) to the power amplifier 2A.

As illustrated in Fig. 2, the tracker circuit 1 includes a pre-regulator circuit 10, a switched-capacitor circuit 20, a power modulation circuit 30, a filter circuit 40, a digital control circuit 60, an input terminal 110, and the output terminals 141 and 142.

The pre-regulator circuit 10 includes a power inductor and a switch. A power inductor is an inductor used to increase, decrease, or both increase and decrease direct current (DC) voltage. A power inductor is arranged in series with a DC path. Note that a power inductor may be connected (arranged in parallel) between a DC path and ground. The pre-regulator circuit 10 can use a power inductor to convert the input voltage into a regulated voltage. The pre-regulator circuit 10 can then output the regulated voltage to the switched-capacitor circuit 20. In addition, the pre-regulator circuit 10 can also output the input or regulated voltage to the power amplifier 2B via the output terminal 142. Such a pre-regulator circuit 10 may also be referred to as a magnetic regulator or a DC/DC converter.

The switched-capacitor circuit 20 includes multiple capacitors and multiple switches and can generate multiple discrete voltages on the basis of the regulated voltage from the pre-regulator circuit 10. The multiple discrete voltages have multiple respective discrete voltage levels. The switched-capacitor circuit 20 may also be referred to as a switched-capacitor voltage ladder.

The power modulation circuit 30 is configured to modulate the power supply voltage by selecting at least one voltage from the multiple discrete voltages generated by the switched-capacitor circuit 20. The power modulation circuit 30 is configured to output the at least one selected voltage to the power amplifier 2A via the output terminal 141. The power modulation circuit 30 is controlled on the basis of a digital control signal.

The filter circuit 40 is connected between the power modulation circuit 30 and the power amplifier 2A. The filter circuit 40 is a pulse shaping network and is configured to filter the at least one voltage selected by the power modulation circuit 30.

The digital control circuit 60 can control the pre-regulator circuit 10, the switched-capacitor circuit 20, and the power modulation circuit 30 on the basis of a digital control signal from the RFIC 5.

The input terminal 110 is an input terminal for DC voltage. That is, the input terminal 110 is a terminal for receiving input voltage from the DC power source 50.

The output terminal 141 is an example of a first output terminal and is an output terminal for the power supply voltage V_{ET}. That is, the output terminal 141 is a terminal for supplying voltage to the power amplifier 2A.

The output terminal 142 is an example of a second output terminal and is an output terminal for the power supply voltage V_{2G}. That is, the output terminal 142 is a terminal for supplying voltage to the power amplifier 2B.

Note that the tracker circuit 1 does not have to include at least one of the pre-regulator circuit 10, the switched-capacitor circuit 20, the power modulation circuit 30, the filter circuit 40, and the digital control circuit 60. For example, the tracker circuit 1 may include the pre-regulator circuit 10, the switched-capacitor circuit 20, the power modulation circuit 30, and the digital control circuit 60 but does not have to include the filter circuit 40. Moreover, any combination of the pre-regulator circuit 10, the switched-capacitor circuit 20, the power modulation circuit 30, and the filter circuit 40 may be integrated into a single circuit.

The power amplifier 2A is an example of a first amplifier and is connected between the RFIC 5 and the filter 3A. Furthermore, the power amplifier 2A is connected to the tracker circuit 1 and the PA control circuit **4.** The power amplifier 2A can use the power supply voltage V_{ET} received from the tracker circuit 1 to amplify an RF signal received from the RFIC **5.**

The power amplifier 2B is an example of a second amplifier and is connected between the RFIC 5 and the filter **3B.** Furthermore, the power amplifier 2B is connected to the tracker circuit 1 and the PA control circuit **4.** The power amplifier 2B can use the power supply voltage V_{2G} received from the tracker circuit 1 to amplify an RF signal received from the RFIC 5.

The filter 3A is connected between the power amplifier 2A and the antenna **6.** The filter 3B is connected between the power amplifier 2B and the antenna 6. The filters 3A and 3B have pass bands that include the frequency bands used for transmitting RF signals. The frequency bands used for transmitting RF signals are predefined by standardizing bodies (for example, 3rd Generation Partnership Project (3GPP^{®}) and Institute of Electrical and Electronics Engineers (IEEE)).

In the present embodiment, RF signals are wireless communication signals in communication networks established using radio access technology (RAT). RF signals may be signals in the frequency band below six gigahertz or may be millimeter-wave signals.

Note that millimeter wave signals generally refer to signals in the range of 30 to 300 GHz but may also be signals in the range of 24.25 to 52.6 GHz (Frequency Region (FR) 2 in 5GNR).

Examples of communication systems include cellular systems (the 5th Generation New Radio (5GNR), the 4th Generation Long Term Evolution (4GLTE), and the 2nd Generation Global System of Mobile Communications (2GGSM)) and wireless local area network (WLAN) systems.

The PA control circuit 4 can control the power amplifiers 2A and 2B. Specifically, the PA control circuit 4 can supply bias control signals to the power amplifiers 2A and 2B.

The RFIC 5 is an example of a signal processing circuit that processes RF signals. Specifically, the RFIC 5 processes an input transmission signal using, for example, up-conversion and supplies the RF transmission signal generated by performing the signal processing to the power amplifiers 2A and 2B. The RFIC 5 also has a control unit that controls the tracker circuit 1. Note that some or all of the functions of the RFIC 5 serving as the control unit may be implemented outside of the RFIC 5.

The antenna 6 transmits the RF signal input from the power amplifier 2A via the filter 3A and the RF signal input from the power amplifier 2B via the filter 3B. The antenna 6 does not have to be included in the communication device 7.

The DC power source 50 can supply DC voltage to the tracker circuit 1. For example, a rechargeable battery can be used as the DC power source 50, but the DC power source 50 is not limited to this.

Note that the circuit configuration of the communication device 7 illustrated in Fig. 2 is an example and is not limited to this. For example, the communication device 7 may include a baseband signal processing circuit that processes signals using an intermediate frequency band that is lower in frequency than the RF signals supplied by the RFIC 5. For example, the communication device 7 may also include a receive path. In this case, a low-noise amplifier and a filter, for example, may be connected to the receive path. For example, the communication device 7 does not have to include the antenna 6, the DC power source 50, or both the antenna 6 and the DC power source 50.

### [1.2 Circuit Configuration of Tracker Circuit 1]

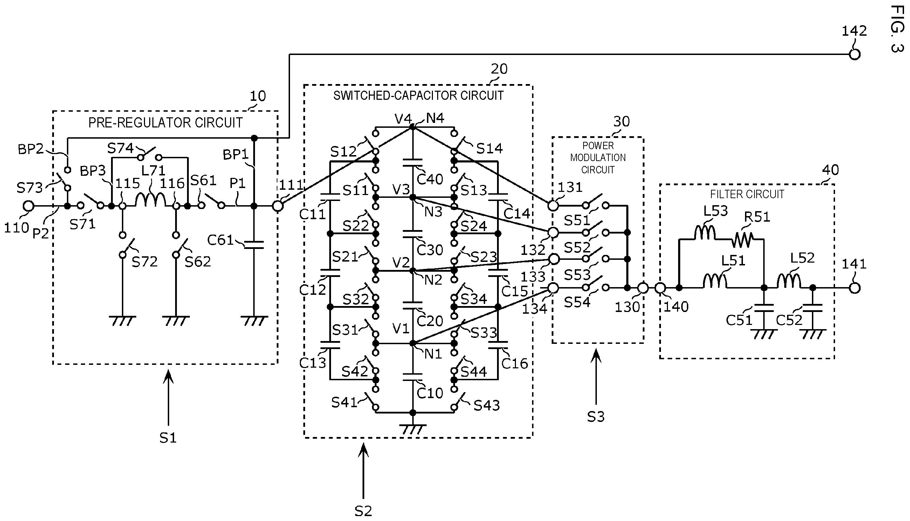

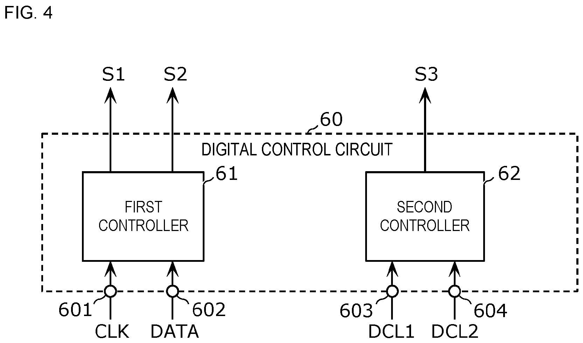

Next, the circuit configuration of the pre-regulator circuit 10, switched-capacitor circuit 20, power modulation circuit 30, filter circuit 40, and digital control circuit 60 included in the tracker circuit 1 will be described with reference to Figs. 3 and 4. Fig. 3 is a circuit configuration diagram of the pre-regulator circuit 10, switched-capacitor circuit 20, power modulation circuit 30, and filter circuit 40 according to the present embodiment. Fig. 4 is a circuit configuration diagram of the digital control circuit 60 according to the present embodiment.

Note that Figs. 3 and 4 illustrate example circuit configurations, and the pre-regulator circuit 10, the switched-capacitor circuit 20, the power modulation circuit 30, the filter circuit 40, and the digital control circuit 60 can be implemented using any of a wide variety of circuit implementations and circuit techniques. Thus, the description of each circuit provided below is not to be interpreted in a limited manner.

### [1.2.1 Circuit Configuration of Switched-Capacitor Circuit 20]

First, the circuit configuration of the switched-capacitor circuit 20 will be described. The switched-capacitor circuit 20 includes, as illustrated in Fig. 3, capacitors C11 to C16, capacitors C10, C20, C30, and C40, and switches S11 to S14, S21 to S24, S31 to S34, and S41 to S44. Energy and electric charge are input at nodes N1 to N4 from the pre-regulator circuit 10 into the switched-capacitor circuit 20 and taken out at the nodes N1 to N4 from the switched-capacitor circuit 20 to the power modulation circuit 30.

Each of the capacitors C11 to C16 functions as a flying capacitor, which may also be referred to as a transfer capacitor. That is, each of the capacitors C11 to C16 is used to increase or decrease the regulated voltage supplied from the pre-regulator circuit 10. More specifically, the capacitors C11 to C16 cause electric charge to move between the capacitors C11 to C16 and the four nodes N1 to N4 so that voltages V1 to V4 (voltages relative to ground potential) satisfying V1:V2:V3:V4 = 1:2:3:4 are maintained at the nodes N1 to N4. These voltages V1 to V4 correspond to multiple second voltages having multiple respective discrete voltage levels.

The capacitor C11 is an example of a first capacitor and has two electrodes. One of the two electrodes of the capacitor C11 is an example of a first electrode and is connected to one end of the switch S11 and one end of the switch S12. The other of the two electrodes of the capacitor C11 is an example of a second electrode and is connected to one end of the switch S21 and one end of the switch S22.

The capacitor C12 has two electrodes. One of the two electrodes of the capacitor C12 is connected to the one end of the switch S21 and the one end of the switch S22. The other of the two electrodes of the capacitor C12 is connected to one end of the switch S31 and one end of the switch S32.

The capacitor C13 has two electrodes. One of the two electrodes of the capacitor C13 is connected to the one end of the switch S31 and the one end of the switch S32. The other of the two electrodes of the capacitor C13 is connected to one end of the switch S41 and one end of the switch S42.

The capacitor C14 is an example of a second capacitor and has two electrodes. One of the two electrodes of the capacitor C14 is an example of a third electrode and is connected to one end of the switch S13 and one end of the switch S14. The other of the two electrodes of the capacitor C14 is an example of a fourth electrode and is connected to one end of the switch S23 and one end of the switch S24.

The capacitor C15 has two electrodes. One of the two electrodes of the capacitor C15 is connected to the one end of the switch S23 and the one end of the switch S24. The other of the two electrodes of the capacitor C15 is connected to one end of the switch S33 and one end of the switch S34.

The capacitor C16 has two electrodes. One of the two electrodes of the capacitor C16 is connected to the one end of the switch S33 and the one end of the switch S34. The other of the two electrodes of the capacitor C16 is connected to one end of the switch S43 and one end of the switch S44.

The set of the capacitors C11 and C14, the set of the capacitors C12 and C15, and the set of the capacitors C13 and C16 can each be charged and discharged in a complementary manner by repeating a first phase and a second phase.

Specifically, in the first phase, the switches S12, S13, S22, S23, S32, S33, S42, and S43 are turned on. As a result, for example, the one of the two electrodes of the capacitor C12 is connected to the node N3, the other of the two electrodes of the capacitor C12 and the one of the two electrodes of the capacitor C15 are connected to the node N2, and the other of the two electrodes of the capacitor C15 is connected to the node N1.

In contrast, in the second phase, the switches S11, S14, S21, S24, S31, S34, S41, and S44 are turned on. As a result, for example, the one of the two electrodes of the capacitor C15 is connected to the node N3, the other of the two electrodes of the capacitor C15 and the one of the two electrodes of the capacitor C12 are connected to the node N2, and the other of the two electrodes of the capacitor C12 is connected to the node N1.

These first and second phases are repeated so that, for example, while one of the capacitors C12 and C15 is being charged from the node N2, the other of the capacitors C12 and C15 can be discharged to the capacitor C30. That is, the capacitors C12 and C15 can be charged and discharged in a complementary manner.

Similarly to the set of the capacitors C12 and C15, the set of the capacitors C11 and C14 and the set of the capacitors C13 and C16 can each be charged and discharged in a complementary manner by repeating the first phase and the second phase.

Each of the capacitors C10, C20, C30, and C40 functions as a smoothing capacitor. That is, each of the capacitors C10, C20, C30, and C40 is used to hold and smooth the voltages V1 to V4 at the nodes N1 to N4.

The capacitor C10 is connected between the node N1 and ground. Specifically, one of two electrodes of the capacitor C10 is connected to the node N1. In contrast, the other of the two electrodes of the capacitor C10 is connected to ground.

The capacitor C20 is connected between the nodes N2 and N1. Specifically, one of two electrodes of the capacitor C20 is connected to the node N2. In contrast, the other of the two electrodes of the capacitor C20 is connected to the node N1.

The capacitor C30 is connected between the nodes N3 and N2. Specifically, one of two electrodes of the capacitor C30 is connected to the node N3. In contrast, the other of the two electrodes of the capacitor C30 is connected to the node N2.

The capacitor C40 is connected between the nodes N4 and N3. Specifically, one of two electrodes of the capacitor C40 is connected to the node N4. In contrast, the other of the two electrodes of the capacitor C40 is connected to the node N3.

The switch S11 is an example of a first switch and is connected between the one of the two electrodes of the capacitor C11 and the node N3. Specifically, the one end of the switch S11 is connected to the one of the two electrodes of the capacitor C11. In contrast, the other end of the switch S11 is connected to the node N3.

The switch S12 is an example of a third switch and is connected between the one of the two electrodes of the capacitor C11 and the node N4. Specifically, the one end of the switch S12 is connected to the one of the two electrodes of the capacitor C11. In contrast, the other end of the switch S12 is connected to the node N4.

The switch S21 is an example of a fourth switch and is connected between the one of the two electrodes of the capacitor C12 and the node N2. Specifically, the one end of the switch S21 is connected to the one of the two electrodes of the capacitor C12 and the other of the two electrodes of the capacitor C11. In contrast, the other end of the switch S21 is connected to the node N2.

The switch S22 is an example of a second switch and is connected between the one of the two electrodes of the capacitor C12 and the node N3. Specifically, the one end of the switch S22 is connected to the one of the two electrodes of the capacitor C12 and the other of the two electrodes of the capacitor C11. In contrast, the other end of the switch S22 is connected to the node N3.

The switch S31 is connected between the other of the two electrodes of the capacitor C12 and the node N1. Specifically, the one end of the switch S31 is connected to the other of the two electrodes of the capacitor C12 and the one of the two electrodes of the capacitor C13. In contrast, the other end of the switch S31 is connected to the node N1.

The switch S32 is connected between the other of the two electrodes of the capacitor C12 and the node N2. Specifically, the one end of the switch S32 is connected to the other of the two electrodes of the capacitor C12 and the one of the two electrodes of the capacitor C13. In contrast, the other end of the switch S32 is connected to the node N2. That is, the other end of the switch S32 is connected to the other end of the switch S21.

The switch S41 is connected between the other of the two electrodes of the capacitor C13 and ground. Specifically, the one end of the switch S41 is connected to the other of the two electrodes of the capacitor C13. In contrast, the other end of the switch S41 is connected to ground.

The switch S42 is connected between the other of the two electrodes of the capacitor C13 and the node N1. Specifically, one end of the switch S42 is connected to the other of the two electrodes of the capacitor C13. In contrast, the other end of the switch S42 is connected to the node N1. That is, the other end of the switch S42 is connected to the other end of the switch S31.

The switch S13 is an example of a fifth switch and is connected between the one of the two electrodes of the capacitor C14 and the node N3. Specifically, the one end of the switch S13 is connected to the one of the two electrodes of the capacitor C14. In contrast, the other end of the switch S13 is connected to the node N3. That is, the other end of the switch S13 is connected to the other end of the switch S11 and the other end of the switch S22.

The switch S14 is an example of a seventh switch and is connected between the one of the two electrodes of the capacitor C14 and the node N4. Specifically, the one end of the switch S14 is connected to the one of the two electrodes of the capacitor C14. In contrast, the other end of the switch S14 is connected to the node N4. That is, the other end of the switch S14 is connected to the other end of the switch S12.

The switch S23 is an example of an eighth switch and is connected between the one of the two electrodes of the capacitor C15 and the node N2. Specifically, the one end of the switch S23 is connected to the one of the two electrodes of the capacitor C15 and the other of the two electrodes of the capacitor C14. In contrast, the other end of the switch S23 is connected to the node N2. That is, the other end of the switch S23 is connected to the other end of the switch S21 and the other end of the switch S32.

The switch S24 is an example of a sixth switch and is connected between the one of the two electrodes of the capacitor C15 and the node N3. Specifically, the one end of the switch S24 is connected to the one of the two electrodes of the capacitor C15 and the other of the two electrodes of the capacitor C14. In contrast, the other end of the switch S24 is connected to the node N3. That is, the other end of the switch S24 is connected to the other end of the switch S11, the other end of the switch S22, and the other end of the switch S13.

The switch S33 is connected between the other of the two electrodes of the capacitor C15 and the node N1. Specifically, the one end of the switch S33 is connected to the other of the two electrodes of the capacitor C15 and the one of the two electrodes of the capacitor C16. In contrast, the other end of the switch S33 is connected to the node N1. That is, the other end of the switch S33 is connected to the other end of the switch S31 and the other end of the switch S42.

The switch S34 is connected between the other of the two electrodes of the capacitor C15 and the node N2. Specifically, the one end of the switch S34 is connected to the other of the two electrodes of the capacitor C15 and the one of the two electrodes of the capacitor C16. In contrast, the other end of the switch S34 is connected to the node N2. That is, the other end of the switch S34 is connected to the other end of the switch S21, the other end of the switch S32, and the other end of the switch S23.

The switch S43 is connected between the other of the two electrodes of the capacitor C16 and ground. Specifically, the one end of the switch S43 is connected to the other of the two electrodes of the capacitor C16. In contrast, the other end of the switch S43 is connected to ground.

The switch S44 is connected between the other of the two electrodes of the capacitor C16 and the node N1. Specifically, the one end of the switch S44 is connected to the other of the two electrodes of the capacitor C16. In contrast, the other end of the switch S44 is connected to the node N1. That is, the other end of the switch S44 is connected to the other end of the switch S31, the other end of the switch S42, and the other end of the switch S33.

A first set of switches including the switches S12, S13, S22, S23, S32, S33, S42, and S43 and a second set of switches including the switches S11, S14, S21, S24, S31, S34, S41, and S44 are switched between on and off in a complementary manner on the basis of a control signal S2. Specifically, in the first phase, the first set of switches is turned on, and the second set of switches is turned off. In contrast, in the second phase, the first set of switches is turned off, and the second set of switches is turned on.

For example, charging from the capacitors C11 to C13 to the capacitors C10 to C40 is performed in one of the first and second phases, and charging from the capacitors C14 to C16 to the capacitors C10 to C40 is performed in the other of the first and second phases. That is, since the capacitors C10 to C40 are constantly charged from the capacitors C11 to C13 or the capacitors C14 to C16, even in a case where current flows at high speed from the nodes N1 to N4 to the power modulation circuit 30, the nodes N1 to N4 are replenished with electric charge at high speed, thereby suppressing potential variations at the nodes N1 to N4.

By operating in this manner, the switched-capacitor circuit 20 can maintain approximately equal voltages at both ends of each of the capacitors C10, C20, C30, and C40. Specifically, the voltages V1 to V4 (voltages relative to ground potential) that satisfy V1:V2:V3:V4 = 1:2:3:4 are maintained at the four nodes labeled V1 to V4. The voltage levels of the voltages V1 to V4 correspond to the multiple discrete voltage levels that the switched-capacitor circuit 20 can supply to the power modulation circuit 30.

Note that the voltage ratio (V1:V2:V3:V4) is not limited to (1:2:3:4). For example, the voltage ratio (V1:V2:V3:V4) may be (1:2:4:8).

Moreover, the configuration of the switched-capacitor circuit 20 illustrated in Fig. 3 is an example and is not limited to this. In Fig. 3, the switched-capacitor circuit 20 is configured to be capable of supplying voltages with four discrete voltage levels but is not limited to this. The switched-capacitor circuit 20 may be configured to be capable of supplying voltages with any number of discrete voltage levels, starting from two. For example, in a case where the switched-capacitor circuit 20 supplies voltages with two discrete voltage levels, it is sufficient that the switched-capacitor circuit 20 have at least the capacitors C12 and C15 and the switches S21 to S24 and S31 to S34.

### [1.2.2 Circuit Configuration of Power Modulation Circuit 30]

Next, the circuit configuration of the power modulation circuit 30 will be described. The power modulation circuit 30 is connected to the digital control circuit 60. As illustrated in Fig. 3, the power modulation circuit 30 includes input terminals 131 to 134, switches S51 to S54, and an output terminal 130.

The output terminal 130 is connected to the filter circuit 40. The output terminal 130 is a terminal for supplying power supply voltage, which is selected from the voltages V1 to V4, to the power amplifier 2A via the filter circuit 40.

The input terminals 131 to 134 are connected to the nodes N4 to N1 of the switched-capacitor circuit 20, respectively. The input terminals 131 to 134 are terminals for receiving the voltages V4 to V1 from the switched-capacitor circuit 20.

The switch S51 is an example of a tenth switch and is connected between the input terminal 131 and the output terminal 130. Specifically, the switch S51 has a terminal connected to the input terminal 131 and a terminal connected to the output terminal 130. In this connection configuration, the switch S51 can be switched between on and off by a control signal S3 to switch between connection and disconnection of the input terminal 131 and the output terminal 130.

The switch S52 is an example of a ninth switch and is connected between the input terminal 132 and the output terminal 130. Specifically, the switch S52 has a terminal connected to the input terminal 132 and a terminal connected to the output terminal 130. In this connection configuration, the switch S52 can be switched between on and off by the control signal S3 to switch between connection and disconnection of the input terminal 132 and the output terminal 130.

The switch S53 is connected between the input terminal 133 and the output terminal 130. Specifically, the switch S53 has a terminal connected to the input terminal 133 and a terminal connected to the output terminal 130. In this connection configuration, the switch S53 can be switched between on and off by the control signal S3 to switch between connection and disconnection of the input terminal 133 and the output terminal 130.

The switch S54 is connected between the input terminal 134 and the output terminal 130. Specifically, the switch S54 has a terminal connected to the input terminal 134 and a terminal connected to the output terminal 130. In this connection configuration, the switch S54 can be switched between on and off by the control signal S3 to switch between connection and disconnection of the input terminal 134 and the output terminal 130.

These switches S51 to S54 are controlled to be turned on exclusively. That is, only one of the switches S51 to S54 is turned on, and the rest of the switches S51 to S54 are turned off. This allows the power modulation circuit 30 to output one voltage selected from the voltages V1 to V4.

Note that the configuration of the power modulation circuit 30 illustrated in Fig. 3 is an example and is not limited to this. In particular, the switches S51 to S54 can be of any configuration, as long as any of the four input terminals 131 to 134 can be selected and connected to the output terminal 130. For example, the power modulation circuit 30 may further include a switch connected between the switches S51 to S53 and the switch S54 and output terminal 130. For example, the power modulation circuit 30 may further include a switch connected between the switches S51 and S52 and the switches S53 and S54 and output terminal 130.

Note that in a case where voltages with two discrete voltage levels are supplied from the switched-capacitor circuit 20, it is sufficient that the power modulation circuit 30 include at least two out of the switches S51 to S54.

### [1.2.3 Circuit Configuration of Pre-Regulator Circuit 10]

First, the configuration of the pre-regulator circuit 10 will be described. As illustrated in Fig. 3, the pre-regulator circuit 10 includes an output terminal 111, inductor connection terminals 115 and 116, switches S61, S62, S71, and S72, a power inductor L71, and a capacitor C61.

The output terminal 111 is an output terminal for the voltage V4. That is, the output terminal 111 is a terminal for supplying the voltage V4 to the switched-capacitor circuit 20. The output terminal 111 is connected to the node N4 of the switched-capacitor circuit 20.

The inductor connection terminal 115 is connected to one end of the power inductor L71. The inductor connection terminal 116 is connected to the other end of the power inductor L71.

The switch S71 is an example of an eleventh switch and is connected between the input terminal 110 and the one end of the power inductor L71. Specifically, the switch S71 has a terminal connected to the input terminal 110 and a terminal connected to the one end of the power inductor L71 with the inductor connection terminal 115 interposed therebetween. In this connection configuration, the switch S71 can be switched between on and off on the basis of a control signal S1 to switch between connection and disconnection of the input terminal 110 and the one end of the power inductor L71.

The switch S72 is an example of a twelfth switch and is connected between the one end of the power inductor L71 and ground. Specifically, the switch S72 has a terminal connected to the one end of the power inductor L71 with the inductor connection terminal 115 interposed therebetween, and a terminal connected to ground. In this connection configuration, the switch S72 can be switched between on and off on the basis of the control signal S1 to switch between connection and disconnection of the one end of the power inductor L71 and ground.

The switch S61 is connected between the other end of the power inductor L71 and the output terminal 111. Specifically, the switch S61 has a terminal connected to the other end of the power inductor L71 with the inductor connection terminal 116 interposed therebetween, and a terminal connected to the output terminal 111. In this connection configuration, the switch S61 can be switched between on and off on the basis of the control signal S1 to switch between connection and disconnection of the other end of the power inductor L71 and the output terminal 111.

The switch S62 is connected between the other end of the power inductor L71 and ground. Specifically, the switch S62 has a terminal connected to the other end of the power inductor L71 with the inductor connection terminal 116 interposed therebetween, and a terminal connected to ground. In this connection configuration, the switch S62 can be switched between on and off by the control signal S1 to switch between connection and disconnection of the other end of the power inductor L71 and ground.

One of two electrodes of the capacitor C61 is connected to the switch S61 and the output terminal 111. The other of the two electrodes of the capacitor C61 is connected to ground. The capacitor C61 functions as a smoothing capacitor. Note that the capacitor C61 does not have to be included in the pre-regulator circuit 10.

The pre-regulator circuit 10 further includes bypass paths BP1 to BP3 and switches S73 and S74.

The bypass path BP1 is an example of a first bypass path and is configured to bypass the switched-capacitor circuit 20, the power modulation circuit 30, and the filter circuit 40. The bypass path BP1 connects a path P1 between the power inductor L71 and the switched-capacitor circuit 20 to the output terminal 142 without going through the switched-capacitor circuit 20, the power modulation circuit 30, and the filter circuit 40. Specifically, the bypass path BP1 connects a point on the path P1 between the power inductor L71 and the switched-capacitor circuit 20 to the output terminal 142. A point refers to a node on the path between elements and is interpreted as the entire path in a case where the impedance of the path is sufficiently low.

Note that a switch is not connected to the bypass path BP1. That is, the bypass path BP1 steadily connects the path P1 to the output terminal 142. Thus, in a case where the power amplifier 2B is operating, the pre-regulator circuit 10 can supply the input voltage received from the DC power source 50 or the regulated voltage converted from the input voltage to the power amplifier 2B via the bypass path BP1 and the output terminal 142.

The bypass path BP2 is an example of a second bypass path and is configured to bypass the power inductor L71, the switched-capacitor circuit 20, the power modulation circuit 30, and the filter circuit 40. The bypass path BP2 connects a path P2 between the DC power source 50 and the power inductor L71 to the output terminal 142 without going through the power inductor L71, the switched-capacitor circuit 20, the power modulation circuit 30, and the filter circuit 40. Specifically, the bypass path BP2 connects a point on the path P2 between the input terminal 110 and the switch S71 to the output terminal 142.

Note that the switch S73 is connected to the bypass path BP2. The switch S73 can switch the bypass path BP2 between electrically conducting and non-conducting states. Thus, in a case where the power amplifier 2B is enabled, the switch S73 allows electrical conduction through the bypass path BP2, which allows the pre-regulator circuit 10 to supply the input voltage received from the DC power source 50 to the power amplifier 2B via the bypass path BP2 and the output terminal 142.

The bypass path BP3 is an example of a third bypass path and is configured to bypass the power inductor. The bypass path BP3 connects the path P2 to the path P1. Specifically, the bypass path BP3 connects a point on the path P2 between the switch S71 and the inductor connection terminal 115 to a point on the path P1 between the inductor connection terminal 116 and the switch S62.

Note that the switch S74 is connected to the bypass path BP3. The switch S74 can switch the bypass path BP3 between electrically conducting and non-conducting states. Thus, in a case where the power amplifier 2B is enabled, the switch S74 allows electrical conduction through the bypass path BP3, which allows the pre-regulator circuit 10 to supply the input voltages received from the DC power source 50 to the power amplifier 2B via the bypass paths BP3 and BP1 and the output terminal 142.

The switch S73 is an example of a thirteenth switch and is configured to switch the bypass path BP2 between electrically conducting and non-conducting states. Specifically, the switch S73 includes a terminal connected to the path P2 and a terminal connected to the output terminal 142. In this connection configuration, the switch S73 can switch the bypass path BP2 between the electrically conducting and non-conducting states by switching the two terminals between connecting and disconnecting states. Note that a low-dropout (LDO) regulator may be used instead of the switch S73.

The switch S74 is an example of a fourteenth switch and is configured to switch the bypass path BP3 between electrically conducting and non-conducting states. Specifically, the switch S74 includes a terminal connected to the path P2 and a terminal connected to the path P1. In this connection configuration, the switch S73 can switch the bypass path BP3 between the electrically conducting and non-conducting states by switching the two terminals between connecting and disconnecting states.

The pre-regulator circuit 10 configured in this manner can supply electric charge to the switched-capacitor circuit 20 via the output terminal 111.

Note that in the present embodiment, the pre-regulator circuit 10 is a buck-boost converter but may also be a buck converter or a boost converter. For example, in a case where the pre-regulator circuit 10 is a buck converter, the pre-regulator circuit 10 does not have to include the switches S61 and S62. Moreover, for example, in a case where the pre-regulator circuit 10 is a boost converter, the pre-regulator circuit 10 does not have to include the switches S71 and S72. In addition, the pre-regulator circuit 10 does not have to include the bypass paths BP2, and BP3 and the switches S73 and S74.

### [1.2.4 Circuit Configuration of Filter Circuit 40]

Next, the circuit configuration of the filter circuit 40 will be described. In the present embodiment, the filter circuit 40 has a low-pass response and is configured to filter voltage received via an input terminal 140 and output the filtered voltage to the output terminal 141. Specifically, as illustrated in Fig. 3, the filter circuit 40 includes inductors L51 to L53, capacitors C51 and C52, a resistor R51, and the input terminal 140.

The input terminal 140 is an input terminal for the voltage selected by the power modulation circuit 30. That is, the input terminal 140 is a terminal for receiving a voltage selected from the multiple voltages V1 to V4.

The inductors L51 to L53, the capacitors C51 and C52, and the resistor R51 constitute a low pass filter (LPF). This allows the filter circuit 40 to reduce a radio frequency (RF) component included in the power supply voltage.

Note that the configuration of the filter circuit 40 illustrated in Fig. 3 is an example and is not limited to this. For example, the filter circuit 40 does not have to include the inductor L53 and the resistor R51. Moreover, for example, the filter circuit 40 may include an inductor connected to one of two electrodes of the capacitor C51 and may include an inductor connected to one of two electrodes of the capacitor C52. The filter circuit 40 may be partially or completely composed of parasitic reactance, parasitic resistance, or a combination of both. Parasitic reactance includes, for example, the inductance, capacitance, or both the inductance and capacitance of the metal wiring line (metal trace) connecting two nodes. Parasitic resistance includes, for example, the resistance of the metal wiring line connecting two nodes.

### [1.2.5 Circuit Configuration of Digital Control Circuit 60]

Next, the circuit configuration of the digital control circuit 60 will be described. As illustrated in Fig. 4, the digital control circuit 60 includes a first controller 61, a second controller 62, and control terminals 601 to 604.

The first controller 61 can process a source-synchronous digital control signal received from the RFIC 5 via the control terminals 601 and 602 to generate the control signals S1 and S2. The control signal S1 is a signal for controlling the on and off of the switches S61, S62, S71, and S72 included in the pre-regulator circuit 10. The control signal S2 is a signal for controlling the on and off of the switches S11 to S14, S21 to S24, S31 to S34, and S41 to S44 included in the switched-capacitor circuit 20. Moreover, a feedback signal for controlling the pre-regulator circuit 10 may be input to the first controller 61.

Note that the digital control signal processed by the first controller 61 is not limited to source-synchronous digital control signals. For example, the first controller 61 may process clock-embedded digital control signals. Moreover, the first controller 61 may generate a control signal for controlling the power modulation circuit 30.

In the present embodiment, one set of clock and data signals are used as the digital control signal for the pre-regulator circuit 10 and the switched-capacitor circuit 20 but digital control signals are not limited to this. For example, as digital control signals for the pre-regulator circuit 10 and the switched-capacitor circuit 20, sets of clock and data signals may be used in a respective manner.

The second controller 62 processes digital control level (DCL) signals (DCL1, DCL2) received from the RFIC 5 via the control terminals 603 and 604 to generate the control signal S3. The DCL signals (DCL1, DCL2) are generated by the RFIC 5 on the basis of the envelope signal or average power of the radio frequency (RF) signal. The control signal S3 is a signal for controlling the on and off of the switches S51 to S54 included in the power modulation circuit 30.

Each of the DCL signals (DCL1, DCL2) is a 1-bit signal. Each of the voltages V1 to V4 is represented by a combination of two 1-bit signals. For example, V1, V2, V3, and V4 are represented by "00", "01", "10", and "11", respectively. Gray code may be used to represent voltage levels.

A capacitor C81 is connected between the first controller 61 and ground. For example, the capacitor C81 is connected between the power line supplying power to the first controller 61 and ground and functions as a bypass capacitor. A capacitor C82 is connected between the second controller 62 and ground.

Note that in the present embodiment, two digital control level signals are used to control the power modulation circuit 30; however, the number of digital control level signals is not limited to this. For example, any number of digital control level signals may be used, such as one, three, or more, depending on the number of voltage levels each of which the power modulation circuit 30 can select. Moreover, the digital control signal used to control the power modulation circuit 30 is not limited to digital control level signals.

### [1.3 Voltage Supply Method]

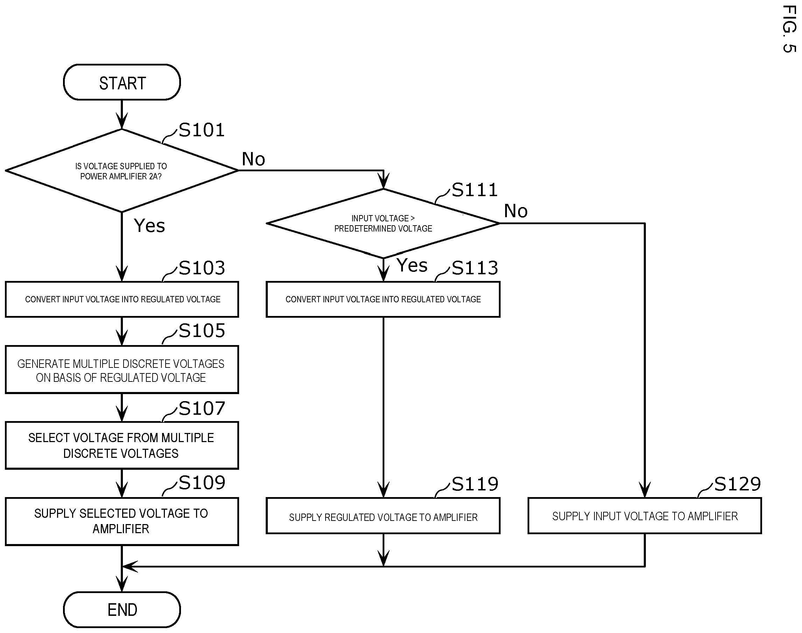

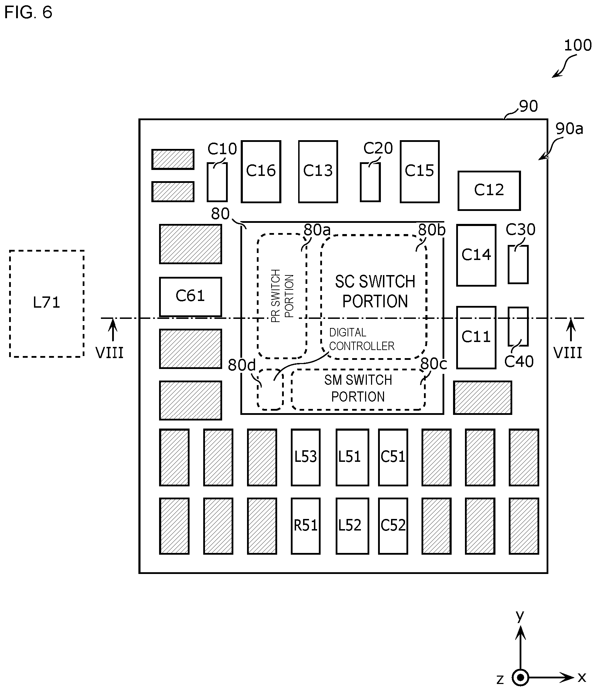

Next, a method for supplying voltage to the power amplifiers 2A and 2B using the tracker circuit 1 configured as described above will be described with reference to Figs. 5 and 6. Fig. 5 is a flowchart illustrating a voltage supply method according to the present embodiment.

In a case where voltage is supplied to the power amplifier 2A (Yes in S101), the pre-regulator circuit 10 converts, on the basis of the control signal S1, the input voltage input from the DC power source 50 into a regulated voltage (S103). In this case, the switches S73 and S74 are turned off, and electrical conduction is not allowed through the bypass paths BP2 and BP3. The switched-capacitor circuit 20 generates, on the basis of the control signal S2, multiple discrete voltages on the basis of the regulated voltage (S105). The power modulation circuit 30 selects at least one voltage from the multiple discrete voltages on the basis of the control signal S3 (S107). The filter circuit 40 filters the selected voltage to supply the resulting voltage to the power amplifier 2A via the output terminal 141 (S109).

In a case where voltage is supplied to the power amplifier 2B (No in S101), when the input voltage is higher than a predetermined voltage (Yes in S111), the pre-regulator circuit 10 converts the input voltage into a regulated voltage on the basis of the control signal S1 (S113). It is sufficient that the predetermined voltage be predetermined empirically, experimentally, or empirically and experimentally, and may be determined on the basis of the voltage needed to amplify the RF signal in the power amplifier 2B. The post-conversion regulated voltage is applied to the output terminal 142 via the bypass path BP1 and supplied to the power amplifier 2B (S119). That is, generation of multiple discrete voltages and selection of at least one voltage are skipped. In this case, the switches S73 and S74 are turned off, and electrical conduction is not allowed through the bypass paths BP2 and BP3.

In a case where voltage is supplied to the power amplifier 2B (No in S101), when the input voltage is not higher than the predetermined voltage (No in S111), the input voltage is applied to the output terminal 142 via the bypass paths BP1 to BP3 and is supplied to the power amplifier 2B (S129). That is, in addition to generation of multiple discrete voltages and selection of at least one voltage, conversion of the input voltage into the regulated voltage is also skipped. In this case, the switches S73 and S74 are turned on, and electrical conduction is allowed through the bypass paths BP2 and BP3.

### [1.4 Component Arrangement in Tracker Module 100]

Next, as an example of implementation of the tracker circuit 1 configured as described above, the tracker module 100 in which the pre-regulator circuit 10, the switched-capacitor circuit 20, the power modulation circuit 30, and the filter circuit 40 are implemented will be described with reference to Figs. 6 to 8. Note that in the present example of implementation, the power inductor L71 included in the pre-regulator circuit 10 is not arranged in or on a module laminate 90 but may be arranged in or on the module laminate 90.

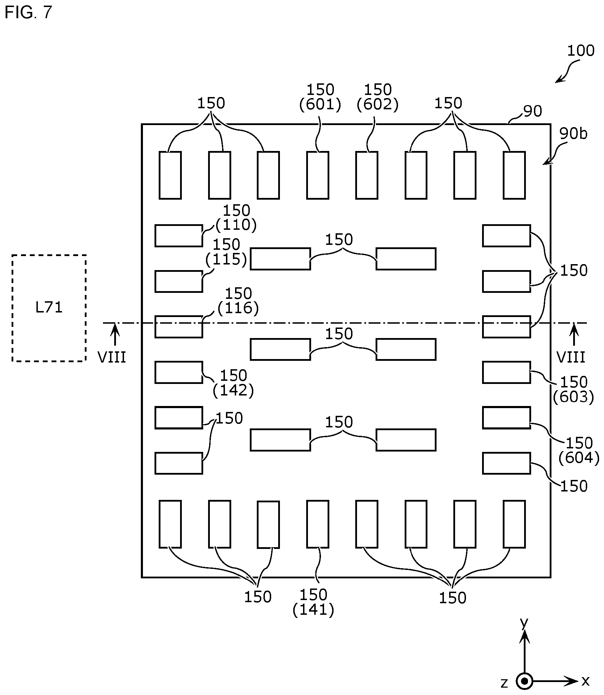

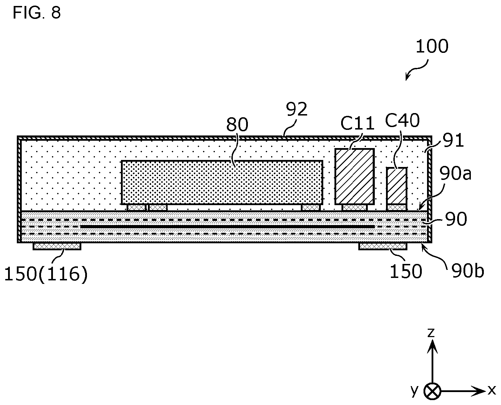

Fig. 6 is a plan view of the tracker module 100 according to the present embodiment. Fig. 7 is a plan view of the tracker module 100 according to the present embodiment and is a view looking through a main surface 90b side of the module laminate 90 from the z-axis positive side. Fig. 8 is a cross-sectional view of the tracker module 100 according to the present embodiment. The cross section of the tracker module 100 in Fig. 8 is the cross section taken along line VIII-VIII of each of Figs. 6 and 7.

Note that in Figs. 6 to 8, some of the wiring lines connecting multiple circuit components arranged in or on the module laminate 90 are omitted. In Figs. 6 and 7, the illustration of a resin member 91 covering multiple circuit components and that of a shield electrode layer 92 covering the surface of the resin member 91 are omitted. In Fig. 6, the hatched blocks represent optional circuit components that are not essential to the present invention.

In addition to multiple circuit components including active elements and passive elements included in the pre-regulator circuit 10, switched-capacitor circuit 20, power modulation circuit 30, and filter circuit 40 illustrated in in Fig. 2, the tracker module 100 includes the module laminate 90, the resin member 91, the shield electrode layer 92, and multiple land electrodes 150.

The module laminate 90 has a main surface 90a and the main surface 90b, which face each other. For example, via conductors, wiring lines, and a ground plane are formed in the module laminate 90 and on the main surface 90a. Note that in Figs. 6 and 7, the module laminate 90 has a rectangular shape in plan view but is not limited to this shape.

As the module laminate 90, for example, a low temperature co-fired ceramics (LTCC) substrate or high temperature co-fired ceramics (HTCC) substrate having a multilayer structure of multiple dielectric layers, a component-embedded board, a substrate having a redistribution layer (RDL), or a printed circuit board can be used; however, the module laminate 90 is not limited to these.

On the main surface 90a, an integrated circuit 80, the capacitors C10 to C16, C20, C30, C40, C51, C52, and C61, the inductors L51 to L53, the resistor R51, and the resin member 91 are arranged.

The integrated circuit 80 has a PR switch portion 80a, an SC switch portion 80b, an SM switch portion 80c, and a digital controller 80d. The PR switch portion 80a includes the switches S61 to S63 and S71 to S74. The SC switch portion 80b includes the switches S11 to S14, S21 to S24, S31 to S34, and S41 to S44. The SM switch portion 80c includes the switches S51 to S54. The digital controller 80d includes the first controller 61 and the second controller 62.

Note that in Fig. 6, the PR switch portion 80a, the SC switch portion 80b, the SM switch portion 80c, and the digital controller 80d are included but do not have to be included in the integrated circuit 80, which is a single integrated circuit. For example, the PR switch portion 80a and the SC switch portion 80b may be included in a single integrated circuit, and the SM switch portion 80c may be included in another integrated circuit. For example, the SC switch portion 80b and the SM switch portion 80c may be included in a single integrated circuit, and the PR switch portion 80a may be included in another integrated circuit. Moreover, the PR switch portion 80a and the SM switch portion 80c may be included in a single integrated circuit, and the SC switch portion 80b may be included in another integrated circuit. For example, the PR switch portion 80a, the SC switch portion 80b, and the SM switch portion 80c may be included in three integrated circuits separately. In this case, the digital controller 80d may be included in each of the multiple integrated circuits or may also be included in only one of the multiple integrated circuits. Note that the multiple integrated circuits can be manufactured at different process technology nodes.

Moreover, in Fig. 6, the integrated circuit 80 has a rectangular shape in the plan view of the module laminate 90 but is not limited to this shape.

The integrated circuit 80 may be configured using complementary metal oxide semiconductor (CMOS), for example, and specifically manufactured using the silicon on insulator (SOI) process. Note that the integrated circuit 80 is not limited to CMOS.

Each of the capacitors C10 to C16, C20, C30, C40, C51, C52, and C61 is mounted as a chip capacitor. A chip capacitor refers to a surface mount device (SMD) that constitutes a capacitor. Note that multiple capacitors to be mounted are not limited to chip capacitors. For example, some or all of the multiple capacitors may be included in an integrated passive device (IPD) or in the integrated circuit 80.

Each of the inductors L51 to L53 is mounted as a chip inductor. A chip inductor refers to an SMD that constitutes an inductor. Note that multiple inductors to be mounted are not limited to chip inductors. For example, the multiple inductors may be included in an IPD.

The resistor R51 is mounted as a chip resistor. A chip resistor refers to an SMD that constitutes a resistor. Note that the resistor R51 to be mounted is not limited to a chip resistor. For example, the resistor R51 may be included in an IPD.

The multiple capacitors, multiple inductors, and multiple resistors arranged on the main surface 90a in this manner are grouped by circuit and are arranged around the integrated circuit 80.

Specifically, the capacitor C61 included in the pre-regulator circuit 10 is arranged in a region on the main surface 90a sandwiched between a straight line along the left side of the integrated circuit 80 and a straight line along the left side of the module laminate 90 in the plan view of the module laminate 90. As a result, the group of circuit components included in the pre-regulator circuit 10 is arranged near the PR switch portion 80a in the integrated circuit 80.

A group formed by the capacitors C10 to C16, C20, C30, and C40 included in the switched-capacitor circuit 20 is arranged in a region on the main surface 90a sandwiched between a straight line along the top side of the integrated circuit 80 and a straight line along the top side of the module laminate 90 and a region on the main surface 90a sandwiched between a straight line along the right side of the integrated circuit 80 and a straight line along the right side of the module laminate 90 in the plan view of the module laminate 90. As a result, the group of circuit components included in the switched-capacitor circuit 20 is arranged near the SC switch portion 80b in the integrated circuit 80. That is, the SC switch portion 80b is arranged closer to the switched-capacitor circuit 20 than each of the PR switch portion 80a and the SM switch portion 80c is.

A group formed by the capacitors C51 and C52, inductors L51 to L53, and resistor R51 included in the filter circuit 40 is arranged in a region on the main surface 90a sandwiched between a straight line along the bottom side of the integrated circuit 80 and a straight line along the bottom side of the module laminate 90 in the plan view of the module laminate 90. As a result, the group of circuit components included in the filter circuit 40 is arranged near the SM switch portion 80c in the integrated circuit 80. That is, the SM switch portion 80c is arranged closer to the filter circuit 40 than each of the PR switch portion 80a and the SC switch portion 80b is.

At least part of the filter circuit 40 is arranged adjacent to the same side, from among the four sides, of the integrated circuit 80 (the bottom side in Fig. 6). Specifically, at least one (the capacitor C51 and the inductors L51 and L53 in Fig. 6) of the circuit components included in the filter circuit 40 is arranged adjacent to the bottom side of the integrated circuit 80.

Multiple land electrodes 150 are arranged on the main surface 90b. The multiple land electrodes 150 function as multiple external connection terminals including a ground terminal in addition to the input terminal 110 illustrated in Fig. 2, the inductor connection terminals 115 and 116, the output terminals 141 and 142, and the control terminals 601 to 604. The multiple land electrodes 150 are electrically connected to multiple electronic components arranged on the main surface 90a through via conductors formed within the module laminate 90. As the multiple land electrodes 150, copper electrodes can be used but are not limited to this. For example, as the multiple land electrodes, solder electrodes may be used. Moreover, instead of the multiple land electrodes 150, multiple bump electrodes or multiple post electrodes may be used as multiple external connection terminals.

The resin member 91 covers the main surface 90a and at least some of the multiple electronic components on the main surface 90a. The resin member 91 has the function of ensuring the reliability, such as mechanical strength and moisture resistance, of the multiple electronic components on the main surface 90a. Note that the resin member 91 does not have to be included in the tracker module 100.

The shield electrode layer 92 is a thin metal film formed by sputtering, for example. The shield electrode layer 92 is formed to cover the surface (top and sides) of the resin member 91. The shield electrode layer 92 is connected to ground, which helps prevent external noise from entering the electronic components that constitute the tracker module 100 and also prevent noise generated by the tracker module 100 from interfering with other modules or devices. Note that the shield electrode layer 92 does not have to be included in the tracker module 100.

Note that the configuration of the tracker module 100 illustrated in Figs. 6 to 8 is an example and is not limited to this. For example, some of the capacitors and inductors arranged on the main surface 90a may be formed within the module laminate 90. Moreover, some of the capacitors and inductors arranged on the main surface 90a do not have to be included in the tracker module 100 or do not have to be arranged in or on the module laminate 90.

### [1.5 Effects, Etc.]

As described above, the tracker circuit 1 according to the present embodiment includes the pre-regulator circuit 10 configured to convert the input voltage into the regulated voltage using the power inductor L71, the switched-capacitor circuit 20 configured to generate multiple discrete voltages on the basis of the regulated voltage, and the power modulation circuit 30 configured to select at least one voltage from the multiple discrete voltages and output the at least one voltage to the output terminal 141, the pre-regulator circuit 10 is configured to output the input voltage or the regulated voltage to the output terminal 142 via the bypass path BP1 configured to bypass the switched-capacitor circuit 20 and power modulation circuit 30, and the bypass path BP1 is configured to connect the path P1 between the power inductor L71 and the switched-capacitor circuit 20 to the output terminal 142.

According to this, the tracker circuit 1 can output the input voltage or the regulated voltage to the output terminal 142 via the bypass path BP1 configured to bypass the switched-capacitor circuit 20 and power modulation circuit 30. Thus, in a case where the multiple discrete voltages are not required to be supplied and the input or regulated voltage is supplied (for example, in the case of the constant voltage mode), the loss of the input or regulated voltage due to the switched-capacitor circuit 20 and the power modulation circuit 30 can be reduced.

For example, in the tracker circuit 1 according to the present embodiment, the pre-regulator circuit 10 may further be configured to output the input voltage to the output terminal 142 via the bypass path BP2 configured to bypass the power inductor L71, the switched-capacitor circuit 20, and the power modulation circuit 30, and the bypass path BP2 may be configured to connect the path P2 between the DC power source 50 and the power inductor L71 to the output terminal 142.

According to this, the tracker circuit 1 can output the input voltage to the output terminal 142 further via the bypass path BP2 configured to bypass the power inductor L71, the switched-capacitor circuit 20, and the power modulation circuit 30. Thus, in a case where the multiple discrete voltages are not required to be supplied and the input voltage is supplied, the loss of the input voltage due to the power inductor L71, the switched-capacitor circuit 20, and the power modulation circuit 30 can be reduced. Since the input voltage is output to the output terminal 142 via the two bypass paths BP1 and BP2, the path resistance can be reduced compared to a case where the input voltage is output to the output terminal 142 via the bypass path BP1 only.

For example, in the tracker circuit 1 according to the present embodiment, the pre-regulator circuit 10 may further include the switch S73 along the bypass path BP2.

According to this, the switch S73 can switch the bypass path BP2 between electrically conducting and non-conducting states, which allows switching and outputting of the input and regulated voltages.

For example, in the tracker circuit 1 according to the present embodiment, the switch S73 of the pre-regulator circuit 10 does not have to allow electrical conduction through the bypass path BP2 in a state where the input voltage is higher than the predetermined voltage, and the switch S73 of the pre-regulator circuit 10 may allow electrical conduction through the bypass path BP2 in a state where the input voltage is lower than the predetermined voltage.

According to this, in a case where the input voltage is higher than the predetermined voltage, the input voltage can be reduced and output to the output terminal 142. Thus, unnecessarily high voltages can be prevented from being supplied to the power amplifier 2B, thereby improving PAE. Furthermore, in a case where the input voltage is lower than the predetermined voltage, the input voltage can be output as is to the output terminal 142 via the bypass paths BP1 and BP2. Thus, the bypass path resistance can be reduced to reduce the loss of the input voltage.

For example, in the tracker circuit 1 according to the present embodiment, the switch S73 of the pre-regulator circuit 10 may be included in the integrated circuit 80 along with the switches S11 to S14 and S21 to S24 included in the switched-capacitor circuit 20.

According to this, an increase in the number of components due to the switch S73 can be suppressed, and the tracker circuit 1 can be downsized.

For example, in the tracker circuit 1 according to the present embodiment, the pre-regulator circuit 10 does not have to include a switch along the bypass path BP1.

According to this, since the tracker circuit 1 does not include a switch along the bypass path BP1, an increase in the resistance of the bypass path BP1 due to the on-resistance of a switch can be suppressed.

For example, in the tracker circuit 1 according to the present embodiment, the pre-regulator circuit 10 may further include a smoothing capacitor C62 connected between ground and the path P1 between the power inductor L71 and the switched-capacitor circuit 20, and the bypass path BP1 may be configured to connect, to the output terminal 142, a point that is between the capacitor C62 and the switched-capacitor circuit 20 and that is on the path P1 between the power inductor L71 and the switched-capacitor circuit 20.

According to this, a point on the path P1 between the smoothing capacitor C62 and the switched-capacitor circuit 20 is connected to the output terminal 142. Thus, in a case where voltage is output to the output terminal 142 via the bypass path BP1, voltage can be smoothed by the capacitor C62, and the voltage output to the output terminal 142 can be stabilized.

For example, in the tracker circuit 1 according to the present embodiment, the pre-regulator circuit 10 may further include the switch S74 configured to switch, between electrically conducting and non-conducting states, the bypass path BP3 configured to bypass the power inductor L71, and the bypass path BP3 may be configured to connect the path P2 between the DC power source 50 and the power inductor L71 to the path P1 between the power inductor L71 and the switched-capacitor circuit 20.

According to this, the tracker circuit 1 can output the input voltage to the output terminal 142 via the bypass paths BP3 and BP1. Thus, in a case where the multiple discrete voltages are not required to be supplied and the input voltage is supplied, not only losses due to the switched-capacitor circuit 20 and the power modulation circuit 30 but also losses due to the power inductor L71 can be reduced.

Moreover, the tracker circuit 1 according to the present embodiment includes the pre-regulator circuit 10, the switched-capacitor circuit 20, which is connected to the pre-regulator circuit 10, the power modulation circuit 30, which is connected to the switched-capacitor circuit 20, the input terminal 110, and the output terminals 141 and 142. The switched-capacitor circuit 20 includes the capacitor C11, which has the first electrode and the second electrode, the capacitor C14, which has the third electrode and the fourth electrode, and the switches S11 to S14 and S21 to S24. The one end of the switch S11 and the one end of the switch S12 are connected to the first electrode. The one end of the switch S22 and the one end of the switch S21 are connected to the second electrode. The one end of the switch S13 and the one end of the switch S14 are connected to the third electrode. The one end of the switch S24 and the one end of the switch S23 are connected to the fourth electrode. The other end of the switch S11, the other end of the switch S22, the other end of the switch S13, and the other end of the switch S24 are connected to each other. The other end of the switch S12 is connected to the other end of the switch S14. The other end of the switch S21 is connected to the other end of the switch S23. The power modulation circuit 30 includes the switch S52 connected between the output terminal 141 and the other ends of the switches S11, S22, S13, and S24, and the switch S51 connected between the output terminal 141 and the other ends of the switches S12 and S14. The pre-regulator circuit 10 includes the switch S71 connected between the input terminal 110 and the one end of the power inductor L71 and the switch S72 connected between the one end of the power inductor L71 and ground. The other end of the power inductor L71 is connected to the other end of the switch S11, the other end of the switch S22, the other end of the switch S13, and the other end of the switch S24. The other end of the power inductor L71 is connected to the output terminal 142 with the bypass path BP1, which is configured to bypass the switched-capacitor circuit 20 and the power modulation circuit 30, interposed therebetween.

According to this, the tracker circuit 1 can output the input voltage or the regulated voltage to the output terminal 142 via the bypass path BP1 configured to bypass the switched-capacitor circuit 20 and power modulation circuit 30. Thus, in a case where the multiple discrete voltages are not required to be supplied and the input or regulated voltage is supplied (for example, in the case of the constant voltage mode), the loss of the input or regulated voltage due to the switched-capacitor circuit 20 and the power modulation circuit 30 can be reduced.

For example, in the tracker circuit 1 according to the present embodiment, the one end of the power inductor L71 may be connected to the output terminal 142 with the bypass path BP2 interposed therebetween, the bypass path BP2 being configured to bypass the power inductor L71, the switched-capacitor circuit 20, and the power modulation circuit 30.

According to this, the tracker circuit 1 can output the input voltage to the output terminal 142 further via the bypass path BP2 configured to bypass the power inductor L71, the switched-capacitor circuit 20, and the power modulation circuit 30. Thus, in a case where the multiple discrete voltages are not required to be supplied and the input voltage is supplied, the loss of the input voltage due to the power inductor L71, the switched-capacitor circuit 20, and the power modulation circuit 30 can be reduced. Since the input voltage is output to the output terminal 142 via the two bypass paths BP1 and BP2, the path resistance can be reduced compared to a case where the input voltage is output to the output terminal 142 via the bypass path BP1 only.

For example, in the tracker circuit 1 according to the present embodiment, the pre-regulator circuit 10 may further include the switch S73 along the bypass path BP2.

According to this, the switch S73 can switch the bypass path BP2 between electrically conducting and non-conducting states, which allows switching and outputting of the input and regulated voltages.

For example, in the tracker circuit 1 according to the present embodiment, the switch S73 does not have to connect the one end of the power inductor L71 to the output terminal 142 with the bypass path BP2 interposed therebetween in a state where the input voltage is higher than the predetermined voltage, and the switch S73 may connect the one end of the power inductor L71 to the output terminal 142 with the bypass path BP2 interposed therebetween in a case where the input voltage is lower than the predetermined voltage.

According to this, in a case where the input voltage is higher than the predetermined voltage, the input voltage can be reduced and output to the output terminal 142. Thus, unnecessarily high voltages can be prevented from being supplied to the power amplifier 2B, thereby improving PAE. Furthermore, in a case where the input voltage is lower than the predetermined voltage, the input voltage can be output as is to the output terminal 142 via the bypass paths BP1 and BP2. Thus, the bypass path resistance can be reduced to reduce the loss of the input voltage.

For example, in the tracker circuit 1 according to the present embodiment, the switch S73 may be included in the integrated circuit 80 along with the switches S11 to S14 and S21 to S24.

According to this, an increase in the number of components due to the switch S73 can be suppressed, and the tracker circuit 1 can be downsized.

For example, in the tracker circuit 1 according to the present embodiment, the pre-regulator circuit 10 does not have to include a switch along the bypass path BP1.

According to this, since the tracker circuit 1 does not include a switch along the bypass path BP1, an increase in the resistance of the bypass path BP1 due to the on-resistance of a switch can be suppressed.

For example, in the tracker circuit 1 according to the present embodiment, the pre-regulator circuit 10 may further include the smoothing capacitor C62 connected between ground and the path P1 between the power inductor L71 and the switched-capacitor circuit 20, and the bypass path BP1 may connect, to the output terminal 142, a point that is between the capacitor C62 and the switched-capacitor circuit 20 and that is on the path P1 between the power inductor L71 and the switched-capacitor circuit 20.

According to this, a point on the path P1 between the smoothing capacitor C62 and the switched-capacitor circuit 20 is connected to the output terminal 142. Thus, in a case where voltage is output to the output terminal 142 via the bypass path BP1, voltage can be smoothed by the capacitor C62, and the voltage output to the output terminal 142 can be stabilized.

For example, in the tracker circuit 1 according to the present embodiment, the pre-regulator circuit 10 may further include the switch S74 along the bypass path BP3 configured to bypass the power inductor L71, and the bypass path BP3 may connect the one end of the power inductor L71 to the other end of the power inductor L71.

According to this, the tracker circuit 1 can output the input voltage to the output terminal 142 via the bypass paths BP3 and BP1. Thus, in a case where the multiple discrete voltages are not required to be supplied and the input voltage is supplied, not only losses due to the switched-capacitor circuit 20 and the power modulation circuit 30 but also losses due to the power inductor L71 can be reduced.

A voltage supply method according to the present embodiment converts an input voltage into a regulated voltage using the power inductor L71 (S103), generates multiple discrete voltages on the basis of the regulated voltage (S105), selects and outputs, to the power amplifier 2A, at least one voltage from the multiple discrete voltages on the basis of the envelope signal of an RF signal (S107 and S109), skips generating multiple discrete voltages and selecting at least one voltage, and supplies the input voltage or the regulated voltage to the power amplifier 2B (S119 or S129).

According to this, in a case where the input voltage or the regulated voltage is supplied to the power amplifier 2B (for example, in the case of the constant voltage mode), the generation of multiple discrete voltages and the selection of at least one voltage can be skipped, thereby reducing losses due to these generation and selection.

In the voltage supply method according to the present embodiment, in a case where the input voltage is higher than the predetermined voltage (Yes in S111), the regulated voltage may be supplied to the power amplifier 2B (S119), and in a case where the input voltage is not higher than the predetermined voltage (No in S111), the conversion of the input voltage into the regulated voltage may be skipped, and the input voltage may be supplied to the power amplifier 2B (S129).

According to this, in a case where the input voltage is higher than the predetermined voltage, the input voltage can be reduced to provide the regulated voltage. Thus, unnecessarily high voltages can be prevented from being supplied to the power amplifier 2B, thereby improving PAE. Furthermore, in a case where the input voltage is lower than the predetermined voltage, the conversion of the input voltage into the regulated voltage can be skipped, thereby reducing losses due to the conversion.

### (Other Embodiments)

The tracker circuits and the voltage supply method according to the present invention have been described above on the basis of the embodiments; however, the tracker circuits and voltage supply methods according to the present invention are not limited to the embodiments described above. The present invention also includes other embodiments realized by combining any of the constituent elements in the above embodiments, modifications obtained by adding, to the above embodiments various, changes that those skilled in the art can conceive of without departing from the gist of the present invention, and various devices in which the above tracker circuit is built.

For example, in the circuit configurations of various circuits according to the above embodiments, another circuit element and another wiring line, for example, may be inserted between individual circuit elements and the paths connecting signal paths disclosed in the drawings. For example, an impedance matching circuit may be inserted between the power amplifier 2A and the filter 3A.

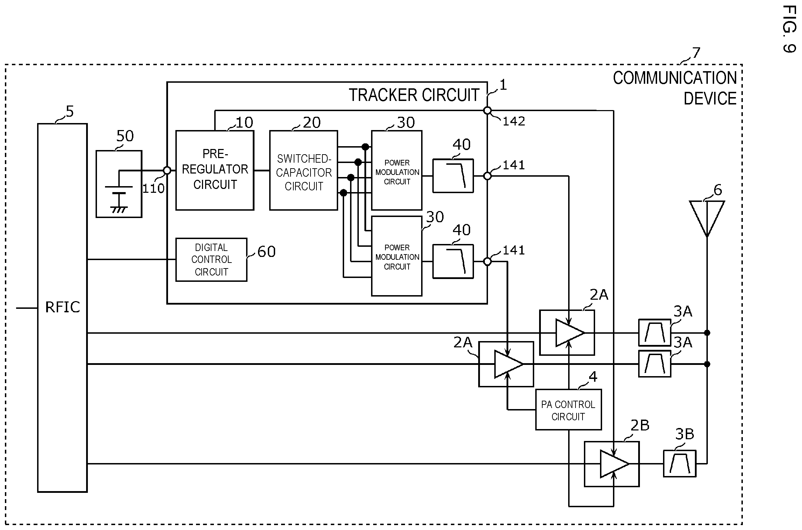

Note that in the above embodiments, the tracker circuit supplies voltage to the two power amplifiers 2A and 2B but may supply voltage to three or more power amplifiers. In this case, the additional power amplifiers may be supplied with the same voltage as the power amplifier 2A or 2B or a different voltage from that of the power amplifiers 2A and 2B. For example, as illustrated in Fig. 9, in a case where two different voltages from each other are supplied to two power amplifiers 2A in the digital ET mode, the tracker circuit 1 may include the pre-regulator circuit 10, the switched-capacitor circuit 20, two power modulation circuits 30, which are connected to the switched-capacitor circuit 20, and two filter circuits 40, which are connected to the two respective power modulation circuits 30. According to this, the two power amplifiers 2A can share the pre-regulator circuit 10 and the switched-capacitor circuit 20, and thus an increase in the number of components can be suppressed.

Note that in the above embodiments, multiple discrete voltages are supplied from the switched-capacitor circuit to the power modulation circuit or circuits, but this is not the only possible case. For example, multiple voltages may be supplied from multiple respective DC-DC converters. Note that in a case where the voltage levels of the multiple discrete voltages are equally spaced, a switched-capacitor circuit is preferably used, which is effective in downsizing the tracker module.

Note that four discrete voltages are supplied in the above embodiments, but the number of discrete voltages is not limited to four. For example, PAE can be improved in a case where multiple discrete voltages include at least the voltage corresponding to the maximum output power and the voltage corresponding to the output power that occurs most frequently.

Note that in the above embodiments, the multiple circuit components of the tracker circuit 1 are arranged on the main surface 90a of the module laminate but may be arranged on both the main surfaces 90a and 90b. In this case, for example, the integrated circuit 80 may be arranged on the main surface 90b.

The following are features of the tracker circuits and voltage supply method described on the basis of the above embodiments.
<1> A tracker circuit includes
   a pre-regulator circuit configured to convert an input voltage into a regulated voltage using a power inductor,
   a switched-capacitor circuit configured to generate a plurality of discrete voltages, based on the regulated voltage, and
   a power modulation circuit configured to select at least one voltage from the plurality of discrete voltages and output the at least one voltage to a first output terminal,
   the pre-regulator circuit is configured to output the input voltage or the regulated voltage to a second output terminal via a first bypass path configured to bypass the switched-capacitor circuit and the power modulation circuit, and
   the first bypass path is configured to connect, to the second output terminal, a path between the power inductor and the switched-capacitor circuit.
<2> The tracker circuit according to <1>, in which
   the pre-regulator circuit is further configured to output the input voltage to the second output terminal via a second bypass path configured to bypass the power inductor, the switched-capacitor circuit, and the power modulation circuit, and
   the second bypass path is configured to connect, to the second output terminal, a path between a direct current power source and the power inductor.
<3> The tracker circuit according to <2>, in which
   the pre-regulator circuit further includes a switch along the second bypass path.
<4> The tracker circuit according to <3>, in which
   in a state where the input voltage is higher than a predetermined voltage, the switch of the pre-regulator circuit does not allow electrical conduction through the second bypass path, and
   in a state where the input voltage is lower than the predetermined voltage, the switch of the pre-regulator circuit allows electrical conduction through the second bypass path.
<5> The tracker circuit according to <3> or <4>, in which
   the switch of the pre-regulator circuit is included in an integrated circuit along with a switch included in the switched-capacitor circuit.
<6> The tracker circuit according to any one of <1> to <5>, in which
   the pre-regulator circuit does not include a switch along the first bypass path.
<7> The tracker circuit according to any one of <1> to <6>, in which
   the pre-regulator circuit further includes a smoothing capacitor connected between ground and the path between the power inductor and the switched-capacitor circuit, and
   the first bypass path is configured to connect, to the second output terminal, a point that is between the smoothing capacitor and the switched-capacitor circuit and that is on the path between the power inductor and the switched-capacitor circuit.
<8> The tracker circuit according to any one of <1> to <7>, in which
   the pre-regulator circuit further includes a switch along a third bypass path configured to bypass the power inductor, and
   the third bypass path is configured to connect a path between a direct current power source and the power inductor to the path between the power inductor and the switched-capacitor circuit.
<9> A tracker circuit includes
   a pre-regulator circuit,
   a switched-capacitor circuit connected to the pre-regulator circuit,
   a power modulation circuit connected to the switched-capacitor circuit,
   an input terminal,
   a first output terminal, and a second output terminal,
   the switched-capacitor circuit includes
      a first capacitor having a first electrode and a second electrode,
      a second capacitor having a third electrode and a fourth electrode,
      a first switch, a second switch, a third switch, a fourth switch, a fifth switch, a sixth switch, a seventh switch, and an eighth switch,
      one end of the first switch and one end of the third switch are connected to the first electrode,
      one end of the second switch and one end of the fourth switch are connected to the second electrode,
      one end of the fifth switch and one end of the seventh switch are connected to the third electrode,
      one end of the sixth switch and one end of the eighth switch are connected to the fourth electrode,
      another end of the first switch, another end of the second switch, another end of the fifth switch, and another end of the sixth switch are connected to each other,
      another end of the third switch is connected to another end of the seventh switch,
      another end of the fourth switch is connected to another end of the eighth switch,
      the power modulation circuit includes
         a ninth switch connected between the first output terminal and the other ends of the first, second, fifth, and sixth switches, and
         a tenth switch connected between the first output terminal and the other ends of the third and seventh switches,
         the pre-regulator circuit includes
            an eleventh switch connected between the input terminal and one end of a power inductor, and
            a twelfth switch connected between the one end of the power inductor and ground,
            another end of the power inductor is connected to the other ends of the first, second, fifth, and sixth switches, and
            the other end of the power inductor is connected to the second output terminal with a first bypass path, which is configured to bypass the switched-capacitor circuit and the power modulation circuit, interposed therebetween.
<10> The tracker circuit according to <9>, in which
   the one end of the power inductor is connected to the second output terminal with a second bypass path interposed therebetween, the second bypass path being configured to bypass the power inductor, the switched-capacitor circuit, and the power modulation circuit.
<11> The tracker circuit according to <10>, in which
   the pre-regulator circuit further includes a thirteenth switch along the second bypass path.
<12> The tracker circuit according to <11>, in which
   in a state where an input voltage is higher than a predetermined voltage, the thirteenth switch does not connect the one end of the power inductor to the second output terminal with the second bypass path interposed therebetween, and
   in a state where the input voltage is lower than the predetermined voltage, the thirteenth switch connects the one end of the power inductor to the second output terminal with the second bypass path interposed therebetween.
<13> The tracker circuit according to <11> or <12>, in which
   the thirteenth switch is included in an integrated circuit along with the first switch, the second switch, the third switch, the fourth switch, the fifth switch, the sixth switch, the seventh switch, and the eighth switch.
<14> The tracker circuit according to any one of <9> to <13>, in which
   the pre-regulator circuit does not include a switch along the first bypass path.
<15> The tracker circuit according to any one of <9> to <14>, in which
   the pre-regulator circuit further includes a third capacitor, which is a smoothing capacitor, connected between ground and a path between the power inductor and the switched-capacitor circuit, and
   the first bypass path connects, to the first output terminal, a point that is between the third capacitor and the switched-capacitor circuit and that is on the path between the power inductor and the switched-capacitor circuit.
<16> The tracker circuit according to any one of <9> to <15>, in which
   the pre-regulator circuit further includes a fourteenth switch along a third bypass path configured to bypass the power inductor, and
   the third bypass path connects the one end of the power inductor to the other end of the power inductor.
<17> A voltage supply method includes
   converting an input voltage into a regulated voltage using a power inductor,
   generating a plurality of discrete voltages, based on the regulated voltage,
   selecting at least one voltage from the plurality of discrete voltages and supplying the at least one voltage to a first amplifier, based on an envelope signal of a radio frequency signal, and
   skipping generation of the plurality of discrete voltages and selection of the at least one voltage, and supplying the input voltage or the regulated voltage to a second amplifier.
<18> The voltage supply method according to <17>, in which
   in a case where the input voltage is higher than a predetermined voltage, the regulated voltage is supplied to the second amplifier, and
   in a case where the input voltage is not higher than the predetermined voltage, conversion of the input voltage into the regulated voltage is skipped, and the input voltage is supplied to the second amplifier.

### Industrial Applicability

The present invention can be widely used in communication devices, such as mobile phones, as a tracker circuit that supplies voltage to a power amplifier.

### Reference Signs List

1 tracker circuit
2A, 2B power amplifier
3A, 3B filter
4 PA control circuit
5 RFIC
6 antenna
7 communication device
10 pre-regulator circuit
20 switched-capacitor circuit
30 power modulation circuit
40 filter circuit
50 direct current power source
60 digital control circuit
61 first controller
62 second controller
80 integrated circuit
80a PR switch portion
80b SC switch portion
80c SM switch portion
80d digital controller
90 module laminate
90a, 90b main surface
91 resin member
92 shield electrode layer
100 tracker module
110, 131, 132, 133, 134, 140 input terminal
111, 112, 113, 114, 130, 141, 142 output terminal
115, 116 inductor connection terminal
150 land electrode
601, 602, 603, 604 control terminal
BP1, BP2, BP3 bypass path
C10, C11, C12, C13, C14, C15, C16, C20, C30, C40, C51, C52, C61, C62, C63, C64, C81, C82 capacitor
L51, L52, L53 inductor
L71 power inductor
N1, N2, N3, N4 node
P1, P2 path
R51 resistor
S1, S2, S3 control signal
S11, S12, S13, S14, S21, S22, S23, S24, S31, S32, S33, S34, S41, S42, S43, S44, S51, S52, S53, S54, S61, S62, S63, S71, S72, S73, S74 switch
V1, V2, V3, V4 voltage
V_{ET}, V_{2G} power supply voltage

## Claims

1. A tracker circuit comprising:
a pre-regulator circuit configured to convert an input voltage into a regulated voltage using a power inductor;
a switched-capacitor circuit configured to generate a plurality of discrete voltages, based on the regulated voltage; and
a power modulation circuit configured to select at least one voltage from the plurality of discrete voltages and output the at least one voltage to a first output terminal, wherein
the pre-regulator circuit is configured to output the input voltage or the regulated voltage to a second output terminal via a first bypass path configured to bypass the switched-capacitor circuit and the power modulation circuit, and
the first bypass path is configured to connect, to the second output terminal, a path between the power inductor and the switched-capacitor circuit.

2. The tracker circuit according to Claim **1,** wherein
the pre-regulator circuit is further configured to output the input voltage to the second output terminal via a second bypass path configured to bypass the power inductor, the switched-capacitor circuit, and the power modulation circuit, and
the second bypass path is configured to connect, to the second output terminal, a path between a direct current power source and the power inductor.

3. The tracker circuit according to Claim **2,** wherein
the pre-regulator circuit further includes a switch along the second bypass path.

4. The tracker circuit according to Claim **3,** wherein
in a state where the input voltage is higher than a predetermined voltage, the switch of the pre-regulator circuit does not allow electrical conduction through the second bypass path, and
in a state where the input voltage is lower than the predetermined voltage, the switch of the pre-regulator circuit allows electrical conduction through the second bypass path.

5. The tracker circuit according to Claim 3 or 4, wherein
the switch of the pre-regulator circuit is included in an integrated circuit along with a switch included in the switched-capacitor circuit.

6. The tracker circuit according to any one of Claims 1 to 5, wherein
the pre-regulator circuit does not include a switch along the first bypass path.

7. The tracker circuit according to any one of Claims 1 to 6, wherein
the pre-regulator circuit further includes a smoothing capacitor connected between ground and the path between the power inductor and the switched-capacitor circuit, and
the first bypass path is configured to connect, to the second output terminal, a point that is between the smoothing capacitor and the switched-capacitor circuit and that is on the path between the power inductor and the switched-capacitor circuit.

8. The tracker circuit according to any one of Claims 1 to 7, wherein
the pre-regulator circuit further includes a switch along a third bypass path configured to bypass the power inductor, and
the third bypass path is configured to connect a path between a direct current power source and the power inductor to the path between the power inductor and the switched-capacitor circuit.

9. A tracker circuit comprising:
a pre-regulator circuit;
a switched-capacitor circuit connected to the pre-regulator circuit;
a power modulation circuit connected to the switched-capacitor circuit;
an input terminal;
a first output terminal; and a second output terminal, wherein
the switched-capacitor circuit includes
a first capacitor having a first electrode and a second electrode,
a second capacitor having a third electrode and a fourth electrode,
a first switch, a second switch, a third switch, a fourth switch, a fifth switch, a sixth switch, a seventh switch, and an eighth switch,
one end of the first switch and one end of the third switch are connected to the first electrode,
one end of the second switch and one end of the fourth switch are connected to the second electrode,
one end of the fifth switch and one end of the seventh switch are connected to the third electrode,
one end of the sixth switch and one end of the eighth switch are connected to the fourth electrode,
another end of the first switch, another end of the second switch, another end of the fifth switch, and another end of the sixth switch are connected to each other,
another end of the third switch is connected to another end of the seventh switch,
another end of the fourth switch is connected to another end of the eighth switch,
the power modulation circuit includes
a ninth switch connected between the first output terminal and the other ends of the first, second, fifth, and sixth switches, and
a tenth switch connected between the first output terminal and the other ends of the third and seventh switches,
the pre-regulator circuit includes
an eleventh switch connected between the input terminal and one end of a power inductor, and
a twelfth switch connected between the one end of the power inductor and ground,
another end of the power inductor is connected to the other ends of the first, second, fifth, and sixth switches, and
the other end of the power inductor is connected to the second output terminal with a first bypass path, which is configured to bypass the switched-capacitor circuit and the power modulation circuit, interposed therebetween.

10. The tracker circuit according to Claim 9, wherein
the one end of the power inductor is connected to the second output terminal with a second bypass path interposed therebetween, the second bypass path being configured to bypass the power inductor, the switched-capacitor circuit, and the power modulation circuit.

11. The tracker circuit according to Claim 10, wherein
the pre-regulator circuit further includes a thirteenth switch along the second bypass path.

12. The tracker circuit according to Claim 11, wherein
in a state where an input voltage is higher than a predetermined voltage, the thirteenth switch does not connect the one end of the power inductor to the second output terminal with the second bypass path interposed therebetween, and
in a state where the input voltage is lower than the predetermined voltage, the thirteenth switch connects the one end of the power inductor to the second output terminal with the second bypass path interposed therebetween.

13. The tracker circuit according to Claim 11 or 12, wherein
the thirteenth switch is included in an integrated circuit along with the first switch, the second switch, the third switch, the fourth switch, the fifth switch, the sixth switch, the seventh switch, and the eighth switch.

14. The tracker circuit according to any one of Claims 9 to 13, wherein
the pre-regulator circuit does not include a switch along the first bypass path.

15. The tracker circuit according to any one of Claims 9 to 14, wherein
the pre-regulator circuit further includes a third capacitor, which is a smoothing capacitor, connected between ground and a path between the power inductor and the switched-capacitor circuit, and
the first bypass path connects, to the first output terminal, a point that is between the third capacitor and the switched-capacitor circuit and that is on the path between the power inductor and the switched-capacitor circuit.

16. The tracker circuit according to any one of Claims 9 to 15, wherein
the pre-regulator circuit further includes a fourteenth switch along a third bypass path configured to bypass the power inductor, and
the third bypass path connects the one end of the power inductor to the other end of the power inductor.

17. A voltage supply method comprising:
converting an input voltage into a regulated voltage using a power inductor;
generating a plurality of discrete voltages, based on the regulated voltage;
selecting at least one voltage from the plurality of discrete voltages and supplying the at least one voltage to a first amplifier, based on an envelope signal of a radio frequency signal; and
skipping generation of the plurality of discrete voltages and selection of the at least one voltage, and supplying the input voltage or the regulated voltage to a second amplifier.

18. The voltage supply method according to Claim 17, wherein
in a case where the input voltage is higher than a predetermined voltage, the regulated voltage is supplied to the second amplifier, and
in a case where the input voltage is not higher than the predetermined voltage, conversion of the input voltage into the regulated voltage is skipped, and the input voltage is supplied to the second amplifier.
